# EUROPEAN PATENT APPLICATION

(11) **EP 4 660 657 A1**
(43) Date of publication of application: **10.12.2025**
(21) Application number: 25181191.5
(22) Date of filing: 05.06.2025
(51) Int. Cl.: G01R 33/36, G01R 33/54

(54) **WIRELESS OPTICAL COMMUNICATION SYSTEM AND WIRELESS OPTICAL COMMUNICATION METHOD**

(30) Priority: 07.06.2024 JP 2024092776
(71) Applicant: FUJI-FILM Corporation, Minato-ku Tokyo 106-8620 (JP)
(72) Inventor: OTA, Atsushi, Tokyo (JP); CHUMAN, Takashi, Tokyo (JP); ISHII, Koki, Tokyo (JP)
(74) Representative: Dehns Germany Partnerschaft mbB

(57) **Abstract**

A wireless communication system includes: a first optical communication device (227) of an optical wireless module that is connected to a receive coil unit (200) attached to a subject (102); and two or more second optical communication devices (10a - 10d) that are provided at a front-side position and a back-side position in a bore (120) of a gantry (110) of an MRI apparatus and capable of performing wireless optical communication with the first optical communication device. A processor (20) is configured to: acquire link-up check information indicating which of the second optical communication devices is to be used through the optical communication between the first optical communication device and the second optical communication devices before main scanning by the MRI apparatus is started; and select a second optical communication device to be used for the main scanning from the second optical communication devices based on the link-up check information and use the selected second optical communication device.

## Description

### BACKGROUND OF THE INVENTION

### 1. Field of the Invention

The present invention relates to a wireless optical communication system and a wireless optical communication, and particularly to a wireless optical communication system and a wireless optical communication method that are applied to a receive coil unit attached to a subject imaged by a magnetic resonance imaging (MRI) apparatus.

### 2. Description of the Related Art

A physical communication cable (coaxial cable) is connected to this type of receive coil unit according to the related art.

An operator needs to perform an operation of attaching a receive coil unit to a subject placed on a top plate of a bed, connecting a connector provided in a communication cable to a connector provided in the bed, and fixing the subject not to move on the top plate. However, the communication cable hinders the workflow of the operator's setting. In addition, for the communication cable, as the number of signals increases due to an increase in the number of channels of the receive coil, the number of coaxial cables increases, which leads to an increase in the size and cost of the device.

In the related art, a magnetic resonance system to which a wireless communication system is applied instead of a physical communication cable has been proposed (JP2008-506441A).

In the wireless communication system described in JP2008-506441A, a magnetic resonance signal is transmitted from a radio frequency (RF) coil component that receives electromagnetic waves in an RF band to a processing device by optical wireless communication, and control and timing signals are transmitted from a scanning controller (scanner) to the RF coil component by optical wireless communication.

In addition, the RF coil component has a plurality of RF coil elements, and the wireless communication system has a plurality of transmitter/receiver modules attached to the RF coil component. Each module has a unit converting an optical signal into an electrical signal and a unit converting an electrical signal into an optical signal and is connected to one of the RF coil elements.

Input and output lenses of each module are directed such that the input and output lenses can communicate with a single corresponding output lens and a single corresponding input lens of the scanner, respectively.

That is, the plurality of transmitter/receiver modules for optical communication are attached to each RF coil element of the RF coil component, and a plurality of optical receivers/transmitters of the scanner are provided at positions corresponding to the plurality of transmitter/receiver modules for optical communication, respectively, and individually perform optical communication with the corresponding transmitter/receiver modules, respectively.

### SUMMARY OF THE INVENTION

In the wireless communication system described in JP2008-506441A, the plurality of transmitter/receiver modules for optical communication attached to each RF coil element of the RF coil component and the plurality of optical receivers/transmitters of the scanner are in one-to-one correspondence with each other and individually perform optical communication therebetween. Therefore, it is difficult to use the plurality of optical receivers/transmitters of the scanner in common for a plurality of types of RF coil components (head coils, spine coils, abdominal coils, various joint coils, and the like) and RF coil components having different numbers of RF coil elements.

The present invention has been made in view of these circumstances, and an object of the present invention is to provide a wireless optical communication system and a wireless optical communication method that can perform good optical communication regardless of, for example, a type of a receive coil unit attached to a subject.

According to a first aspect of the present invention, there is provided a wireless optical communication system including: a first optical communication device that is connected to a receive coil unit attached to a subject; two or more second optical communication devices that are provided at a front-side position and a back-side position in a bore of a gantry of a magnetic resonance imaging apparatus and that are capable of performing wireless optical communication with the first optical communication device; and a processor that controls the optical communication between the first optical communication device and the second optical communication devices. The processor is configured to: execute the optical communication between the first optical communication device and the second optical communication devices before main scanning by the magnetic resonance imaging apparatus is started and acquire link-up check information indicating which of the two or more second optical communication devices is to be used through the optical communication; select the second optical communication device to be used for the main scanning from the two or more second optical communication devices based on the link-up check information; and execute the optical communication between the first optical communication device and the selected second optical communication device and acquire a nuclear magnetic resonance signal received by the second optical communication device through the optical communication in a case where the main scanning is started.

According to the first aspect of the present invention, since the link-up check information indicating which of the two or more second optical communication devices is to be used is acquired by the optical communication before the main scanning, it is possible to select the second optical communication device that can perform good optical communication with the first optical communication device during the main scanning and to perform optical communication (to acquire a good nuclear magnetic resonance signal).

According to a second aspect of the present invention, in the wireless optical communication system according to the first aspect, preferably, the link-up check information is an offset position of the first optical communication device with respect to a reference position of the receive coil unit or a type or model number of the receive coil unit.

In a case where the reference position of the receive coil unit is controlled to be moved to the center of the imaging region in the bore, the offset position of the first optical communication device indicates the relative position of the first optical communication device with respect to the center of the imaging region in the bore. In a case where the position of the first optical communication device in the bore is known, it is possible to select the second optical communication device, which can perform optimal optical communication with the first optical communication device, in the bore.

According to a third aspect of the present invention, in the wireless optical communication system according to the first aspect, preferably, the link-up check information is a reception intensity of a signal received by each of the two or more second optical communication devices, and the processor is configured to: perform pre-scanning using the two or more second optical communication devices before the main scanning is started; and select the second optical communication device to be used for the main scanning based on the reception intensity of the signal received by each of the two or more second optical communication devices in the pre-scanning.

According to the third aspect of the present invention, it is possible to select the optimal second optical communication device having the maximum reception intensity based on the reception intensity of the signal received by each of the two or more second optical communication devices in the pre-scanning.

According to a fourth aspect of the present invention, in the wireless optical communication system according to any one of the first to third aspects, preferably, the receive coil unit includes a memory that stores an offset position of the first optical communication device with respect to a reference position of the receive coil unit or a type or model number of the receive coil unit, and the processor is configured to read out the offset position or the type or model number of the receive coil unit from the memory through the optical communication before the main scanning is started.

According to a fifth aspect of the present invention, in the wireless optical communication system according to the fourth aspect, preferably, the processor is configured to, in a case where the type or model number of the receive coil unit is acquired, acquire the offset position set according to the type or model number of the receive coil unit or information indicating the second optical communication device to be used for the main scanning.

In a case where the type or model number of the receive coil unit can be acquired, it is possible to acquire the offset position corresponding to the type or model number of the receive coil unit stored in the memory in advance based on the acquired type or model number of the receive coil unit. Similarly, it is possible to directly acquire the information indicating which of the two or more second optical communication devices is to be used during the main scanning.

According to a sixth aspect of the present invention, in the wireless optical communication system according to the fourth aspect or the fifth aspect, preferably, the processor is configured to acquire positional information of the first optical communication device above a top plate of a bed on which the subject is placed, based on two or more received signals received by the two or more second optical communication devices through the optical communication before the main scanning is started. The positional information of the first optical communication device can be used to control the position of the top plate of the bed in a case where the top plate is fed into the bore.

According to a seventh aspect of the present invention, preferably, the wireless optical communication system according to the second aspect further includes: a third optical communication device that is capable of performing wireless optical communication with the first optical communication device of the receive coil unit before movement of a top plate of a bed on which the subject is placed is started. Preferably, the processor is configured to execute the optical communication between the first optical communication device and the third optical communication device before the main scanning is started to acquire the offset position of the first optical communication device with respect to the reference position of the receive coil unit or the type or model number of the receive coil unit. Therefore, the offset position of the first optical communication device or the type or model number of the receive coil unit can be successfully acquired by the optical communication with the third optical communication device before the top plate of the bed is moved.

According to an eighth aspect of the present invention, in the wireless optical communication system according to the seventh aspect, preferably, the third optical communication device is provided on a ceiling above the bed.

According to a ninth aspect of the present invention, in the wireless optical communication system according to any one of the first to eighth aspects, preferably, the processor is configured to: acquire information used to control a position of a top plate of a bed on which the subject is placed through the optical communication before the main scanning is started; and automatically or manually control the position of the top plate fed into the bore based on the acquired information such that the receive coil unit is moved to an imaging region in the bore.

According to a tenth aspect of the present invention, in the wireless optical communication system according to the sixth aspect, preferably, the processor is configured to: control a position of the top plate based on the acquired positional information and offset position such that the reference position of the receive coil unit is moved to a center of an imaging region in the bore of the gantry or output assist information for manually moving the top plate and for moving the reference position of the receive coil unit to the center of the imaging region.

According to the tenth aspect of the present invention, it is possible to calculate the reference position of the receive coil unit with respect to the top plate from the positional information of the first optical communication device above the top plate and the offset position of the first optical communication device with respect to the reference position of the receive coil unit. Therefore, the amount of movement of the top plate required to move the reference position of the receive coil unit to the center of the imaging region in the bore can be calculated, and the top plate can be automatically controlled based on the calculated amount of movement such that the reference position of the receive coil unit is moved to the center of the imaging region in the bore, or the assist information indicating, for example, the difference between the current reference position of the receive coil unit and the center of the imaging region can be presented to enable an operator to manually control the position of the top plate such that the reference position of the receive coil unit is moved to the center of the imaging region.

According to an eleventh aspect of the present invention, in the wireless optical communication system according to any one of the first to tenth aspects, preferably, the processor is configured to acquire the link-up check information every repetition period of the main scanning or every several repetition periods of the main scanning.

According to a twelfth aspect of the present invention, there is provided a wireless optical communication method executed by a processor of a wireless optical communication system including a first optical communication device that is connected to a receive coil unit attached to a subject, two or more second optical communication devices that are provided at a front-side position and a back-side position in a bore of a gantry of a magnetic resonance imaging apparatus and that are capable of performing wireless optical communication with the first optical communication device, and the processor that controls the optical communication between the first optical communication device and the second optical communication devices. The wireless optical communication method includes: a step of executing the optical communication between the first optical communication device and the second optical communication devices before main scanning by the magnetic resonance imaging apparatus is started and acquiring link-up check information indicating which of the two or more second optical communication devices is to be used through the optical communication; a step of selecting the second optical communication device to be used for the main scanning from the two or more second optical communication devices based on the link-up check information; and a step of executing the optical communication between the first optical communication device and the selected second optical communication device and acquiring a nuclear magnetic resonance signal received by the second optical communication device through the optical communication in a case where the main scanning is started.

According to the present invention, it is possible to automatically select the second optical communication device that can perform good optical communication with the first optical communication device of the receive coil unit attached to the subject among two or more optical communication devices (second optical communication devices) provided at the front-side position and the back-side position in the bore of the gantry of the magnetic resonance imaging apparatus. Therefore, in a case where the main scanning is performed, it is possible to perform good optical communication with the first optical communication device of the receive coil unit regardless of, for example, the type of the receive coil unit.

### BRIEF DESCRIPTION OF THE DRAWINGS

Fig. 1 is a perspective view showing an appearance of a magnetic resonance imaging apparatus (MRI apparatus) to which a wireless optical communication system according to an embodiment of the present invention is applied.
Fig. 2 is a diagram showing a schematic configuration of an inside of the MRI apparatus shown in Fig. 1.
Fig. 3 is a schematic diagram showing a configuration of a receive coil unit.
Fig. 4 is a block diagram showing an internal configuration of an optical wireless module shown in Fig. 3.
Fig. 5 is a block diagram showing a second optical communication device that is provided in a gantry of the MRI apparatus and a processor that transmits and receives an electrical signal to and from the second optical communication device.
Figs. 6A to 6C are diagrams showing, for example, a positional relationship between the first optical communication device of the receive coil unit and four second optical communication devices disposed in a bore of a gantry of the MRI apparatus before main scanning by the MRI apparatus.
Figs. 7A to 7C are diagrams showing, for example, a positional relationship between the first optical communication device of the receive coil unit and the four second optical communication devices disposed in the bore of the gantry of the MRI apparatus during the main scanning by the MRI apparatus.
Fig. 8 is a flowchart showing an embodiment of a wireless optical communication method according to the embodiment of the present invention.
Fig. 9 is a subroutine showing an example of a process in Step S10 shown in Fig. 8.
Fig. 10 is a diagram showing an example of a pulse sequence of the MRI apparatus.
Fig. 11 is a diagram showing another example of the pulse sequence of the MRI apparatus.
Figs. 12A to 12C are diagrams showing, for example, a positional relationship between the first optical communication device of the receive coil unit and a third optical communication device provided on a ceiling before the main scanning by the MRI apparatus.
Figs. 13A to 13C are diagrams showing, for example, a positional relationship between the first optical communication device of the receive coil unit, the four second optical communication devices disposed in the bore of the gantry of the MRI apparatus, and the third optical communication device provided on a ceiling of an examination room during the main scanning by the MRI apparatus.

### DESCRIPTION OF THE PREFERRED EMBODIMENTS

Hereinafter, preferred embodiments of a wireless optical communication system and a wireless optical communication method according to the present invention will be described with reference to the accompanying drawings.

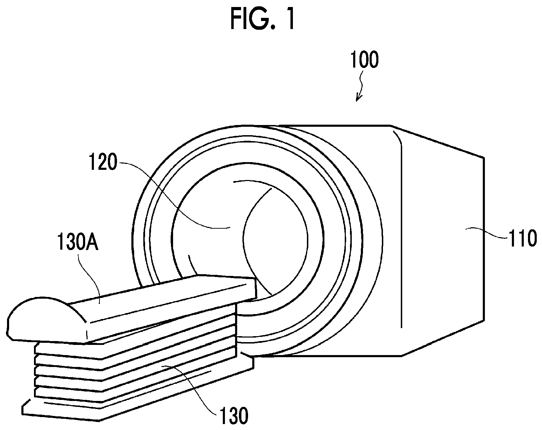

Fig. 1 is a perspective view showing an appearance of a magnetic resonance imaging apparatus (MRI apparatus) to which the wireless optical communication system according to the embodiment of the present invention is applied.

An MRI apparatus 100 shown in Fig. 1 comprises a gantry 110 and a bed 130 comprising a top plate 130A disposed on a front side of a bore 120 which is a cylinder imaging space provided in the gantry 110.

### Internal Configuration of MRI Apparatus

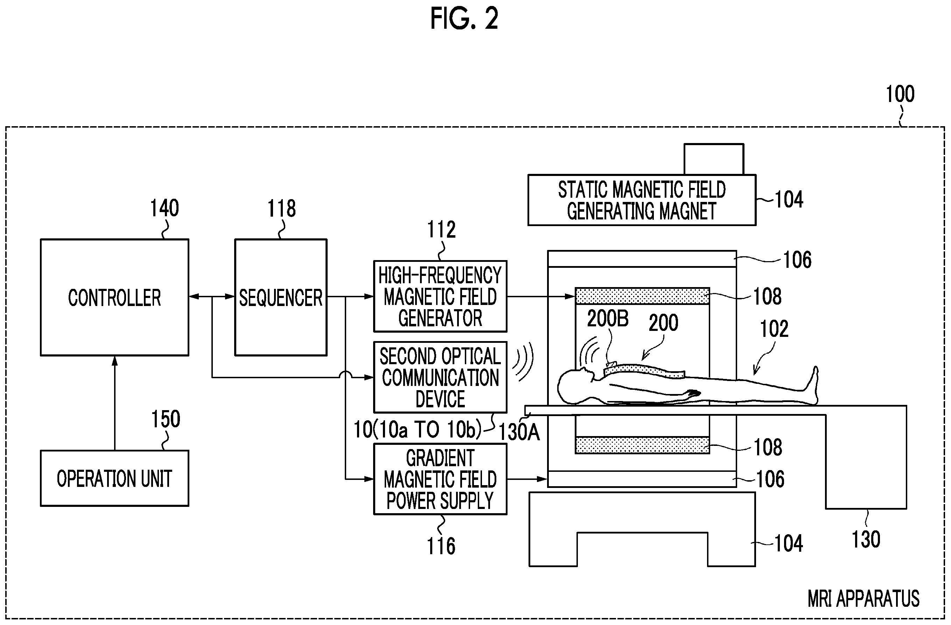

Fig. 2 is a diagram showing a schematic configuration of the inside of the MRI apparatus shown in Fig. 1.

As shown in Fig. 2, the MRI apparatus 100 comprises a static magnetic field generating magnet 104 that generates a uniform static magnetic field in the imaging space in which a subject 102 is disposed, a gradient coil (GC) 106 that generates a gradient magnetic field pulse in the imaging space, a radio frequency (RF) coil (transmission coil) 108 that generates a high-frequency magnetic field for generating a nuclear magnetic resonance signal (NMR signal) in a nucleus of an atom constituting a tissue of the subject 102, and a receive coil unit 200 that detects the NMR signal generated from the subject 102.

As shown in Figs. 1 and 2, the top plate 130A is moved to the bore 120 to move the subject 102 who lies on the top plate 130A of the bed 130 in a supine posture such that an examination part of the subject 102 is positioned in an imaging region (a center of the static magnetic field) in the bore 120.

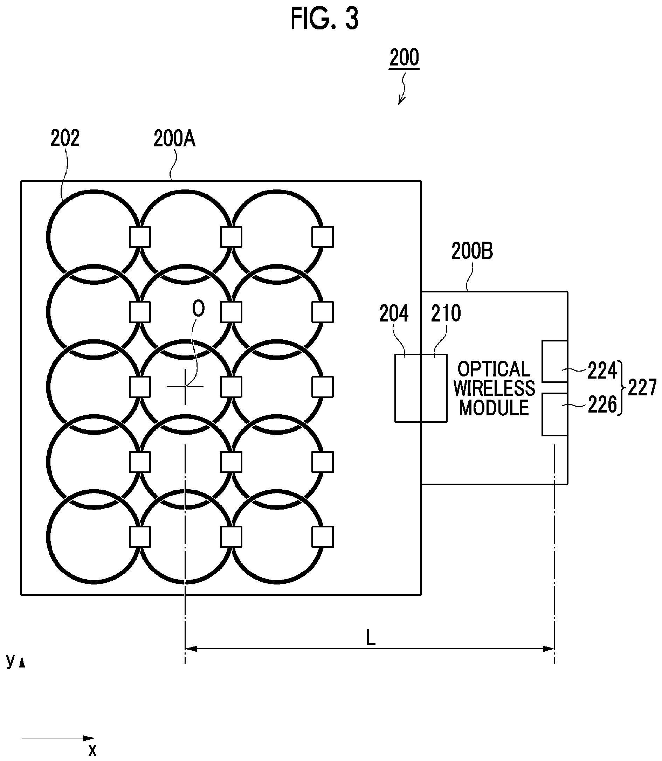

A sequencer 118 sends commands to a high-frequency magnetic field generator 112 and a gradient magnetic field power supply 116 according to an imaging sequence (pulse sequence) to generate a high-frequency magnetic field and a gradient magnetic field, respectively. The generated high-frequency magnetic field is applied as a pulsed high-frequency magnetic field (RF pulse) to the subject 102 through the transmission coil 108. The NMR signal generated from the subject 102 is received by a receive coil 200A (see Fig. 3) constituting the receive coil unit 200, is subjected to signal processing, such as amplification and A/D conversion, by an optical wireless module 200B that is connected to the receive coil 200A and that functions as a first optical communication device, is converted into an optical signal, and is wirelessly transmitted.

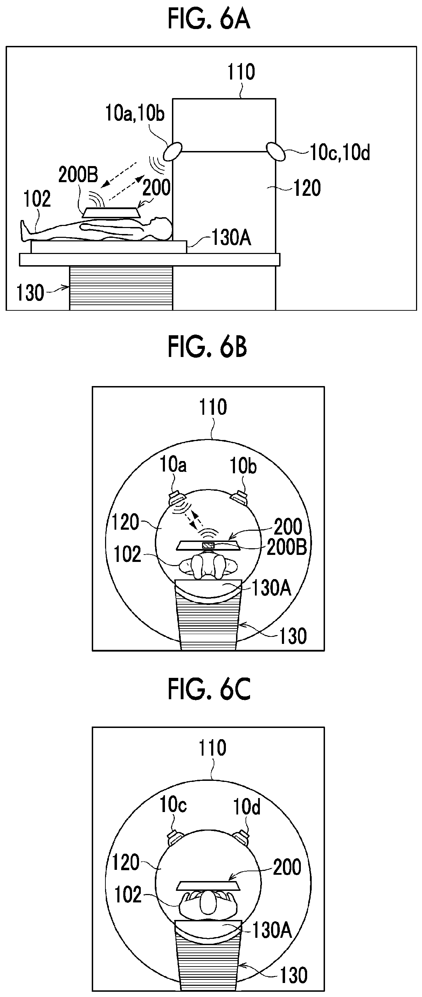

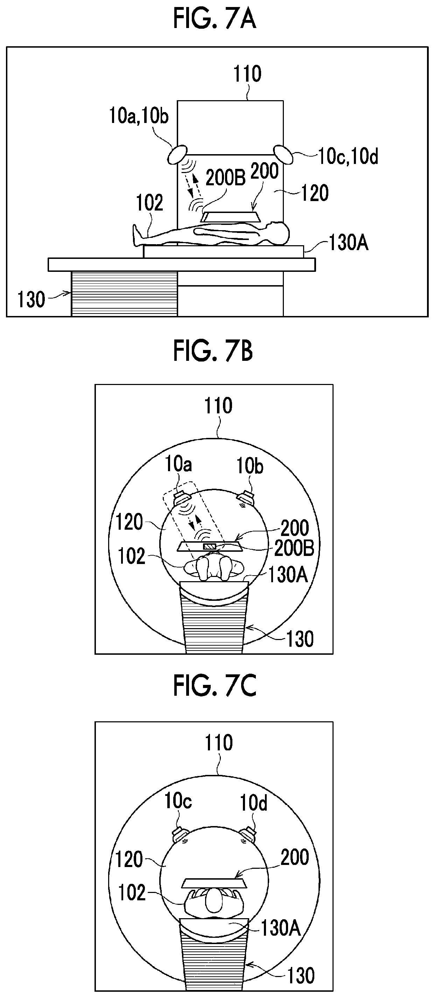

Second optical communication devices 10 (10a to 10d) are two or more optical communication devices that are provided at front-side positions of a ceiling and back-side positions of the ceiling in the bore 120 of the gantry 110. In the present example, the second optical communication devices 10 are configured as the four second optical communication devices 10a to 10d. Each of the four second optical communication devices 10a to 10d performs optical communication with the optical wireless module 200B that functions as the first optical communication device. In addition, in Fig. 2, the second optical communication devices 10 (10a to 10d) are located outside the bore 120 for convenience of description, but are disposed in the bore 120 of the gantry 110 as described in detail with reference to Figs. 6A to 6C and Figs. 7A to 7C.

In addition, the receive coil unit 200 and the second optical communication devices 10a to 10d will be described in detail below.

The gradient magnetic field coil 106 includes gradient magnetic field coils in three directions of the X, Y, and Z directions, each of which generates the gradient magnetic field in response to a signal from the gradient magnetic field power supply 116.

An optical signal indicating the NMR signal received by the second optical communication device 10 is photoelectrically converted and output to the controller 140. The sequencer 118 performs control such that each unit is operated at a pre-programmed timing and intensity. Among programs, a program in which, particularly, the timing and intensity of RF pulses, gradient magnetic fields, and signal reception have been described is referred to as a pulse sequence.

Various pulse sequences are known depending on the purpose, but a detailed description thereof will be omitted here.

The controller 140 controls the operation of the MRI apparatus 100 through the sequencer 118, receives the NMR signal from the second optical communication device 10, and performs various types of signal processing including image reconstruction.

The controller 140 can be configured by a computer. The computer applied to the controller 140 may be a personal computer or a workstation.

The controller 140 receives the input of various instructions from an operation unit 150, controls the overall operation of each unit of the MRI apparatus 100, and executes, for example, a process of performing inverse Fourier transform on the NMR signal (echo signal) input from the second optical communication device 10 to convert the NMR signal into an image in a real space, thereby generating an MRI image.

The operation unit 150 includes a mouse, a keyboard, and the like and functions as a portion of a graphical user interface (GUI) that receives an input from an operator using a display operation window of a display (not shown).

That is, the operation unit 150 and the display function as the GUI for the operator to start and stop (pause) the MRI apparatus 100, to select a pulse sequence, and to input imaging conditions, processing conditions, and the like.

### Receive Coil Unit

Fig. 3 is a schematic diagram showing a configuration of the receive coil unit.

As shown in Fig. 3, the receive coil unit 200 includes the receive coil 200A and the optical wireless module 200B.

The receive coil 200A is a flexible, thin, and lightweight coil that can cover a wide imaging range and can image various examination parts.

In the receive coil 200A shown in Fig. 3, a plurality of loop-shaped coil elements 202 that function as antennas receiving nuclear magnetic resonance signals (NMR signals) are provided. Each coil element 202 is connected in parallel to a connector 204.

The optical wireless module 200B has a connector 210 connected to the connector 204 of the receive coil 200A and is configured to be connected instead of a communication cable (not shown). However, the optical wireless module 200B is not limited to a module that is attachable to and detachable from the receive coil 200A and may be integrated with the receive coil 200A. In addition, the receive coil 200A and the optical wireless module 200B may be connected to each other by a communication cable.

In Fig. 3, the optical wireless module 200B comprises an electrical signal/optical signal (E/O) optical transmitter 224 that functions as an E/O converter and an optical signal/electrical signal (O/E) optical receiver 226 that functions as an O/E converter. In the present example, the E/O optical transmitter 224 and the O/E optical receiver 226 are collectively referred to as a "first optical communication device 227".

The receive coil 200A has 15 coil elements 202 that are arranged in 5 rows and 3 columns, and a reference position O of the receive coil 200A (receive coil unit 200) according to this example is a center position of the coil elements 202 disposed at the center of the 15 coil elements 202.

In addition, the position (offset position) of the first optical communication device 227 with respect to the reference position O is a position that is a distance L away from the reference position O in a right direction in Fig. 3.

In Fig. 3, in a case of an xy coordinate system having the reference position O of the receive coil 200A as a reference, the offset position of the first optical communication device 227 can be represented by coordinates (L, 0). In addition, the x-axis of the xy coordinate system is a feed direction in a case where the receive coil unit 200 is set for the subject 102 on the top plate 130A of the bed 130 and the receive coil unit 200 is fed into the bore 120 together with the subject 102 by the movement of the top plate 130A.

### Configuration of Optical Wireless Module

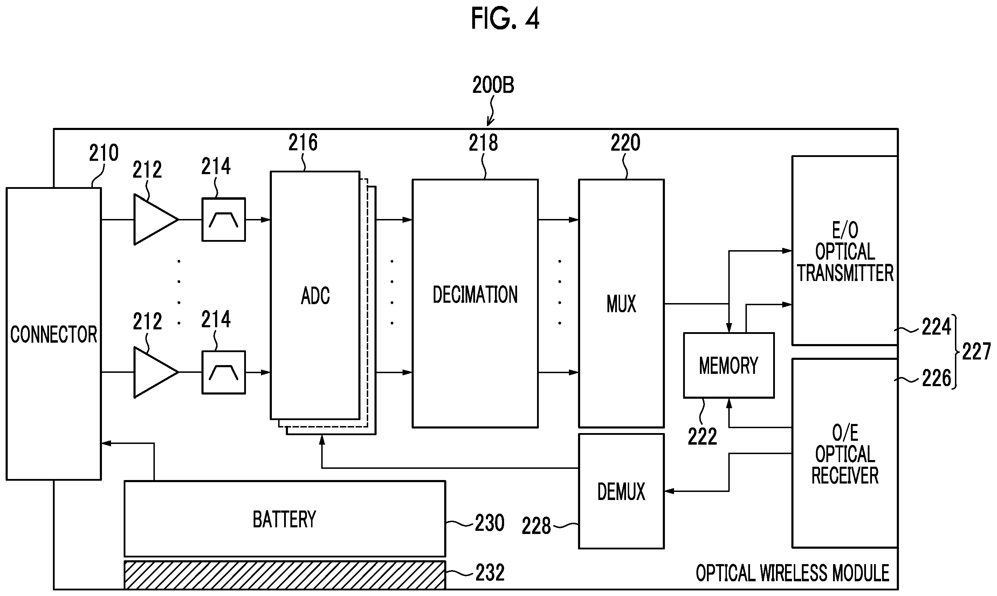

Fig. 4 is a block diagram showing an internal configuration of the optical wireless module shown in Fig. 3.

The optical wireless module 200B shown in Fig. 4 includes the connector 210, a preamplifier 212, a filter 214, an analog/digital (A/D) converter 216, a decimation 218, a multiplexer 220, a memory 222, the first optical communication device 227 including the E/O optical transmitter 224 and the O/E optical receiver 226, a demultiplexer 228, and a battery 230.

The connector 210 is connected to the connector 204 of the receive coil 200A as described in Fig. 3, receives an analog nuclear magnetic resonance signal (NMR signal) from the receive coil 200A, and supplies driving power from the battery 230 to, for example, a decoupling circuit (not shown) of the receive coil 200A.

The analog NMR signals input in parallel from the 15 coil elements 202 of the receive coil 200A through the connector 210 are amplified by the preamplifier 212, and signal components in a desired resonance frequency band are extracted by the filter 214 and are applied to the A/D converter 216.

Among control signals for each control destination subjected to serial/parallel conversion by the demultiplexer 228, a sampling clock of the A/D converter 216 is applied to the A/D converter 216, and the A/D converter 216 converts the analog NMR signal into a digital NMR signal according to the sampling clock and outputs the digital NMR signal to the decimation 218.

The decimation 218 averages the digitized NMR signal, converts the digitized NMR signal into a low-speed multi-bit signal, and outputs the low-speed multi-bit signal to the multiplexer 220. The multiplexer 220 performs time-division multiplexing on a plurality of NMR signals and outputs the multiplexed signal as one signal.

The NMR signal output from the multiplexer 220 is applied to the memory 222 and the E/O optical transmitter 224.

The E/O optical transmitter 224 converts the NMR signal input from the multiplexer 220 into an optical signal and emits (transmits) the converted optical signal. The E/O optical transmitter 224 has, for example, a light emitting diode (preferably, an infrared light emitting diode) and emits NMR signal light converted into an optical signal from the light emitting diode driven based on the NMR signal which is an electrical signal. The NMR signal light emitted from the light emitting diode is emitted with an appropriate angle of view by a projection lens.

The memory 222 temporarily stores transmission data in preparation for a communication failure and outputs the transmission data (NMR signal) to the E/O optical transmitter 224 in response to a data request.

In addition, the memory 222 stores link-up check information indicating which of the two or more second optical communication devices 10a to 10d is to be used as the second optical communication device 10 that performs optical communication with the first optical communication device 227 during the main scanning by the MRI apparatus 100. Here, the offset position of the first optical communication device 227 with respect to the reference position O of the receive coil unit 200 (see Fig. 3) or the type or model number of the receive coil unit 200 can be used as the link-up check information.

Further, in a case where information of the type or model number of the receive coil unit 200 can be acquired, the corresponding offset position can be acquired from a table indicating a relationship between the information of the type or model number of the receive coil unit and the offset position stored in advance in a memory other than the memory 222 based on the acquired information of the type or model number of the receive coil unit. In addition, on the premise that the reference position of the receive coil unit is positioned at the center of the imaging region in the bore, a relationship between the type or model number of the receive coil unit and the second optical communication device to be used among the two or more second optical communication devices may be stored in the memory in advance, and the movement position to which the second optical communication device is to be moved during the main scanning may be acquired based on the type or model number of the receive coil unit.

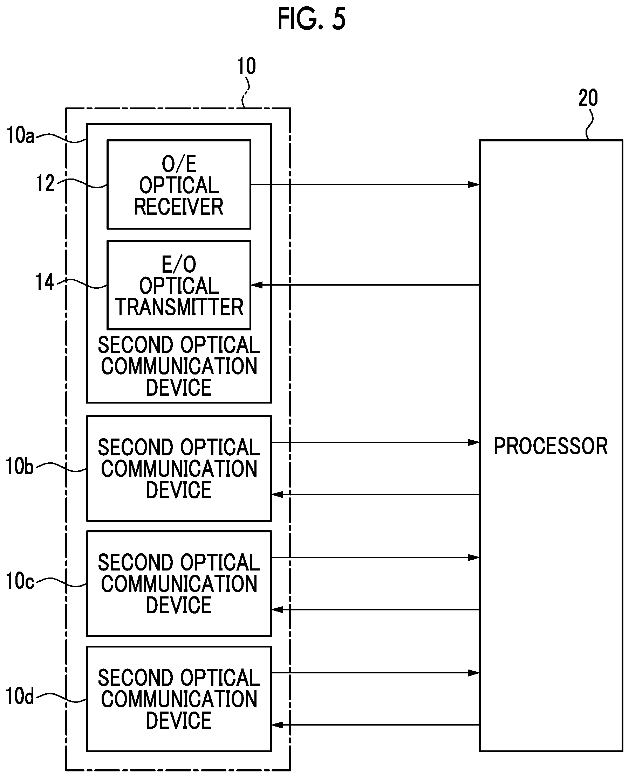

The O/E optical receiver 226 of the optical wireless module 200B is a portion that receives various control signals (control signals obtained by serializing a sampling clock for the A/D converter 216, an operation setting control signal, a control signal for setting digital signal processing in the decimation 218, a control signal for setting the gain of the preamplifier 212, a decoupling control signal for the decoupling circuit of the receive coil 200A, and the like) from a processor 20 of the MRI apparatus 100 shown in Fig. 5 via the second optical communication device 10 and converts the received signals into electrical signals. The O/E optical receiver 226 includes, for example, a condenser lens and a photoelectric conversion element that converts an optical signal condensed by the condenser lens into an electrical signal and outputs various serialized control signals converted by the photoelectric conversion element to the demultiplexer 228.

The demultiplexer 228 performs serial/parallel conversion on various serialized control signals and transmits the parallelized various control signals as control signals for each control destination.

The battery 230 is a battery that is built in the optical wireless module 200B and that can be charged by power supplied from a charging port 232, supplies power to each circuit in the optical wireless module 200B, and supplies power to the receive coil 200A through the connector 210.

Fig. 5 is a block diagram showing the second optical communication devices provided in the gantry of the MRI apparatus and the processor that transmits and receives electrical signals to and from the second optical communication devices.

The processor 20 shown in Fig. 5 is a portion that executes a wireless optical communication method according to the embodiment of the present invention, and the controller 140 shown in Fig. 2 may also have the functions of the processor 20.

The processor 20 executes the optical communication between the first optical communication device 227 and the second optical communication devices 10 before the main scanning by the MRI apparatus 100 is started, acquires the link-up check information indicating which of the two or more second optical communication devices 10a to 10d is to be used through the optical communication, selects the second optical communication device to be used for the main scanning from the two or more second optical communication devices 10a to 10d based on the acquired link-up check information, executes the optical communication between the first optical communication device 227 and the selected second optical communication device 10 in a case where the main scanning is started, and acquires the nuclear magnetic resonance signal (NMR signal) received by the second optical communication device 10 through the optical communication.

The above-mentioned process of the processor 20 will be described in detail below.

In Fig. 5, the second optical communication device 10a comprises an O/E optical receiver 12 and an E/O optical transmitter 14. The O/E optical receiver 12 and the E/O optical transmitter 14 have the same configurations as the O/E optical receiver 226 and the E/O optical transmitter 224 shown in Fig. 4, respectively.

In a case where the first optical communication device 227 of the receive coil unit 200 performs optical communication with the second optical communication device 10a provided in the gantry 110, the O/E optical receiver 12 receives the serialized NMR signal transmitted from the E/O optical transmitter 224 of the first optical communication device 227, converts the serialized NMR signal into an electrical signal, and outputs the electrical signal to the processor 20. The E/O optical transmitter 14 that receives the input of various serialized control signals from the processor 20 converts the various serialized control signals into optical signals and transmits the optical signals. The various serialized optical signals transmitted from the E/O optical transmitter 14 are received by the O/E optical receiver 226 of the receive coil unit 200 and are converted into electrical signals therein.

The second optical communication devices 10b, 10c, and 10d have the same configuration as the second optical communication device 10a and communicate with the processor 20 in the same manner as the second optical communication device 10a.

The four second optical communication devices 10a, 10b, 10c, and 10d are disposed at different positions in the gantry 110.

Positional Relationship Between First Optical Communication Device and Second Optical Communication Device

### State Before Main Scanning

Figs. 6A to 6C are diagrams showing, for example, a positional relationship between the first optical communication device of the receive coil unit and the four second optical communication devices disposed in the bore of the gantry of the MRI apparatus before the main scanning by the MRI apparatus.

Here, the main scanning means the imaging of the subject 102 by the MRI apparatus 100. The term "before the main scanning" shown in Figs. 6A to 6C means a state in which the subject 102 is placed on the top plate 130A of the bed 130 and the setting of the receive coil unit 200 for the subject 102 is completed and before the feeding operation of the subject 102 into the bore 120 by the movement of the top plate 130A is started.

Fig. 6A is a view showing the side of the gantry 110 and the bed 130 of the MRI apparatus, Fig. 6B is a left side view of Fig. 6A as viewed from an entrance side (bed side) of the bore 120, and Fig. 6C is a right side view of Fig. 6A as viewed from an opposite side of the bore 120.

The second optical communication devices 10a and 10b are installed at the front-side (entrance-side) positions in the bore 120 of the gantry 110 as shown in Figs. 6A and 6B and are disposed at the left and right positions of the ceiling in the bore 120 in Fig. 6B.

The second optical communication devices 10c and 10d are installed at the back-side positions in the bore 120 of the gantry 110 as shown in Figs. 6A and 6C and are disposed at the left and right positions of the ceiling in the bore 120 in Fig. 6C.

### State During Main Scanning

Figs. 7A to 7C are diagrams showing, for example, a positional relationship between the first optical communication device of the receive coil unit and the four second optical communication devices disposed in the bore of the gantry of the MRI apparatus during the main scanning by the MRI apparatus.

Figs. 7A to 7C are diagrams corresponding to Figs. 6A to 6C, respectively, and are different from Figs. 6A to 6C in the position of the top plate 130A of the bed 130 (that is, the positions of the subject 102 and the receive coil unit 200).

In a case where the main scanning is performed by the MRI apparatus, the top plate 130A of the bed 130 is fed into the bore 120 of the gantry 110, the reference position O (see Fig. 3) of the receive coil unit 200 set for the subject 102 is moved to the center of the imaging region in the bore 120 of the gantry 110, and then the main scanning is performed. In the example shown in Figs. 7A to 7C, during the main scanning, the second optical communication device 10a is linked up to the first optical communication device of the receive coil unit 200 (optical wireless module 200B), and optical communication of information including the NMR signal and the like is performed.

### Wireless Optical Communication Method

Next, the wireless optical communication method according to the embodiment of the present invention will be described.

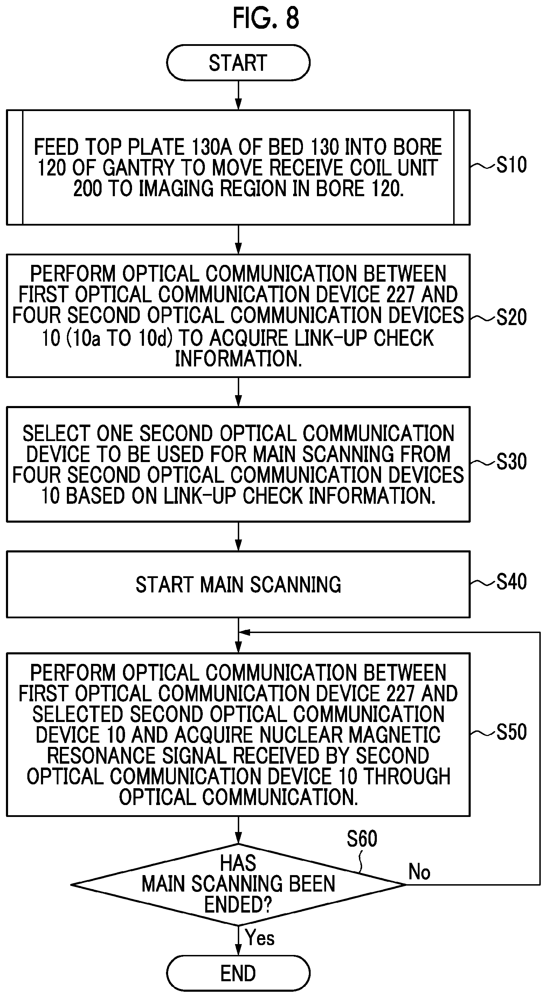

Fig. 8 is a flowchart showing an embodiment of the wireless optical communication method according to the present invention, and the processor 20 shown in Fig. 5 executes a program related to the wireless optical communication method to implement the wireless optical communication method.

In Fig. 8, the processor 20 performs control to feed the top plate 130A of the bed 130 into the bore 120 of the gantry 110 to move the receive coil unit 200 to the imaging region in the bore 120 (Step S10).

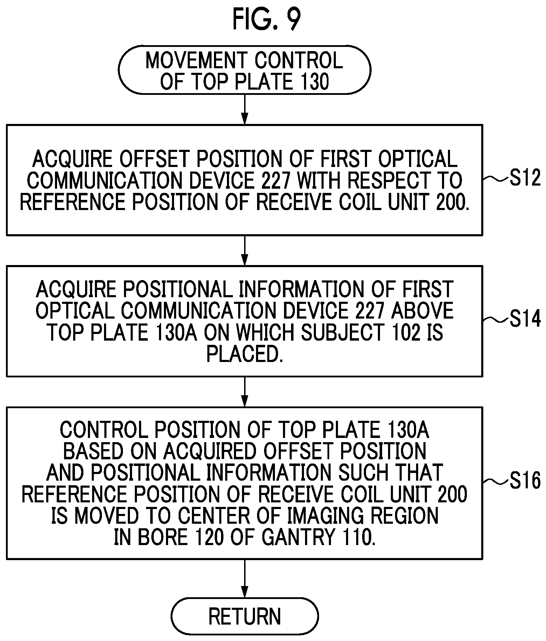

Fig. 9 is a subroutine showing an example of the process in Step S10 shown in Fig. 8.

In Fig. 9, in Step S12, the offset position of the first optical communication device 227 with respect to the reference position of the receive coil unit 200 is acquired as the link-up check information. That is, the processor 20 transmits an "offset position acquisition request" from the second optical communication device 10a to the first optical communication device 227 of the receive coil unit 200 through E/O optical transmission, and the first optical communication device 227 reads out the information indicating the offset position stored in the memory 222 in response to the "offset position acquisition request" received by O/E optical reception and transmits the information indicating the offset position through E/O optical transmission. The processor 20 acquires the information indicating the offset position received by the second optical communication device 10a through O/E optical reception.

In addition, since the second optical communication devices 10a and 10b on the bed side of the bore 120 are closer to the first optical communication device 227 (optical wireless module 200B) of the receive coil unit 200 in the state shown in Figs. 6A to 6C than the second optical communication devices 10c and 10d on the back side of the bore 120, the second optical communication device 10a on the closer side is used for optical communication for the link-up check information. However, the second optical communication device 10b may be used for the optical communication. Further, in a case where a plurality of second optical communication devices 10 can be linked up, it is preferable to acquire a plurality of link-up check information items from the plurality of second optical communication devices 10 that can be linked up. In this case, the processor 20 can compare the plurality of link-up check information items and determine which of the plurality of link-up check information items is correct in a case where there is a difference between the plurality of link-up check information items.

Then, the processor 20 acquires the positional information of the first optical communication device 227 (optical wireless module 200B) above the top plate 130A on which the subject 102 is placed (Step S14).

For the positional information of the first optical communication device 227, an optical signal with a set light intensity is transmitted from the first optical communication device 227, and the positional information of the first optical communication device 227 can be acquired based on, for example, the signal intensity of the optical signal (received signal) received by one or more second optical communication device 10. In this case, a table indicating, for example, the reception intensity of the optical signal received by one or more second optical communication devices 10 is created in advance for each position of the first optical communication device 227, and the positional information of the first optical communication device 227 can be acquired using the table. In addition, for the positional information of the first optical communication device 227, it is possible to acquire the positional information of the first optical communication device 227 from the position of the optical wireless module 200B (first optical communication device 227) in an image captured by a ceiling camera (not shown).

Then, the processor 20 controls the position of the top plate 130A based on the offset position and the positional information acquired in Steps S12 and S14 such that the reference position of the receive coil unit 200 is moved to the center of the imaging region in the bore 120 of the gantry 110 (Step S16).

That is, the processor 20 can calculate the reference position of the receive coil unit 200 at the position of the top plate 130A in the state shown in Figs. 6A to 6C from the acquired offset position and positional information and can also calculate the amount of movement of the top plate 130A required to move the reference position to the center of the imaging region in the bore 120. Therefore, the processor 20 can perform the position control of the top plate 130A for moving the top plate 130A by the calculated amount of movement such that the reference position of the receive coil unit 200 is automatically moved to the center of the imaging region in the bore 120.

In addition, in a case where the top plate 130A is moved by a manual operation, the processor 20 may output assist information for moving the reference position of the receive coil unit 200 to the center of the imaging region to a display for operation or the like. The assist information can be information indicating a difference between the amount of movement calculated as described above and the amount of movement of the top plate 130A by the manual operation.

Returning to Fig. 8, after the reference position of the receive coil unit 200 is controlled to be moved to the center of the imaging region in the bore 120 as shown in Figs. 7A to 7C, the processor 20 performs optical communication (pre-scanning) between the first optical communication device 227 and the four second optical communication devices 10 (10a to 10d) before the main scanning is started to acquire the link-up check information (Step S20).

In this case, the link-up check information can be, for example, the reception intensity of the optical signal which has been transmitted from the first optical communication device 227 of the receive coil unit 200 in the bore 120 through E/O optical transmission and received by the four second optical communication devices 10a to 10d through O/E reception.

The processor 20 selects one second optical communication device to be used for the main scanning from the four second optical communication devices 10 (10a to 10d) based on the link-up check information acquired in Step S20 (Step S30). That is, it is preferable that the processor 20 compares reception states of the received signals received by the four second optical communication devices 10a to 10d through O/E optical reception and selects one second optical communication device 10 having the best reception state. For example, the processor 20 can calculate the reception intensity of each of the received signals received by the four second optical communication devices 10a to 10d through O/E optical reception and select the second optical communication device having the maximum reception intensity.

In addition, the processor 20 can calculate, from the offset position acquired in Step S12 shown in Fig. 9, the position (relative position) of the first optical communication device 227 with respect to the center of the imaging region in the bore 120 in a case where the reference position of the receive coil unit 200 is moved to the center of the imaging region in the bore 120. Therefore, the processor 20 can select one optimal second optical communication device from the four second optical communication devices 10a to 10d based on the relative position of the first optical communication device 227 in the bore 120, instead of the processes in Steps S20 and S30.

Then, in a case where the controller 140 of the MRI apparatus 100 receives an imaging start instruction from the operation unit 150, the controller 140 starts the main scanning according to the imaging sequence through the sequencer 118 (Step S40). During the main scanning, the processor 20 performs the optical communication between the first optical communication device 227 and the second optical communication device 10 selected in Step S30 and acquires the nuclear magnetic resonance signal (NMR signal) received by the second optical communication device 10 through the optical communication (Step S50).

The controller 140 determines whether or not the main scanning has been ended (Step S60). In a case where the main scanning is in progress (in a case of "No"), the acquisition of the NMR signal is repeated in Step S50. In a case where the main scanning has been ended (in a case of "Yes"), the imaging operation of the MRI apparatus 100 is ended.

### Link-Up of Second Optical Communication Device During Main Scanning

The processor 20 performs the optical communication between the optical wireless module 200B (first optical communication device 227) disposed in the receive coil unit 200 and the plurality of second optical communication devices 10 (10a to 10d) installed in the bore 120, using the pre-scanning before the main scanning by the MRI apparatus 100, detects which of the second optical communication devices 10 (10a to 10d) has the highest reception intensity, selects the second optical communication device 10 that is most likely to be linked up first based on the detection results, and uses the selected second optical communication device 10 during the main scanning. However, it is preferable to check the link-up even during the main scanning.

The reason is that a case where the relative position of the receive coil unit 200 (first optical communication device 227) with respect to the center of the imaging region in the bore 120 changes due to the movement of the subject 102 or the like during the main scanning, a case where a defect occurs in the currently selected second optical communication device 10, or the like is considered.

Therefore, it is preferable that the processor 20 acquires the link-up check information even during the main scanning and links up the second optical communication device 10 having better communication conditions.

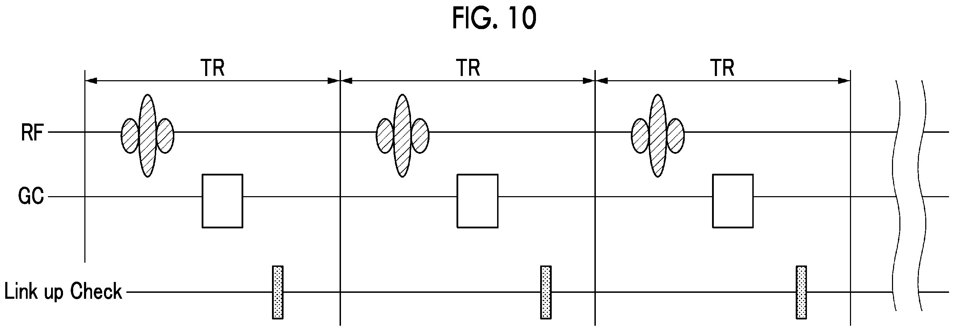

Fig. 10 is a diagram showing an example of a pulse sequence of the MRI apparatus.

As shown in Fig. 10, in the sequence, an RF pulse for excitation, a GC pulse, and the like are repeatedly generated at time intervals of a time to repeat (TR), and an NMR signal (not shown) is collected as an echo signal from the receive coil. The link-up check information is acquired every period of TR.

Here, the link-up check information is the reception intensity of the optical signal received by each of the four second optical communication devices 10a to 10d in a case where the optical signal having the set optical intensity is transmitted from the first optical communication device 227.

The processor 20 selects the second optical communication device 10 having the highest reception intensity based on the link-up check information acquired every period of TR, links up the second optical communication device 10 selected in the previous period of TR in the next period of TR, and acquires the echo signal.

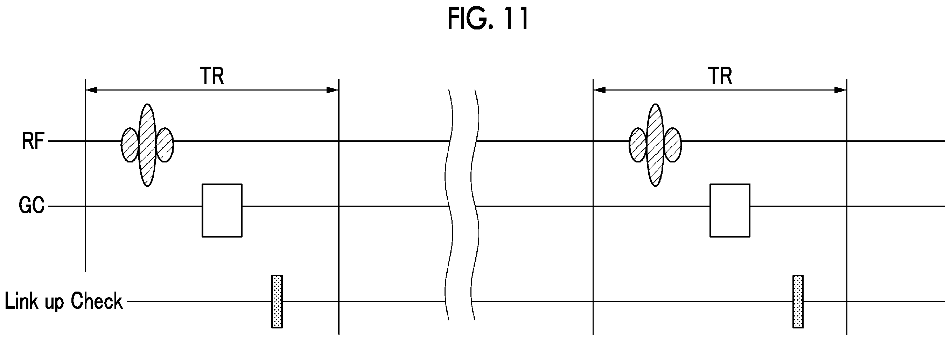

Fig. 11 is a diagram showing another example of the pulse sequence of the MRI apparatus, which is particularly different from the sequence shown in Fig. 10 in the timing when the link-up check information is acquired.

That is, in the sequence shown in Fig. 10, the link-up check information is acquired every period of TR. However, in the sequence shown in Fig. 11, for example, the link-up check information is thinned out and acquired every several periods of TR, and the link-up is checked.

### Another Embodiment of Acquisition of Link-Up Check Information Before Main Scanning

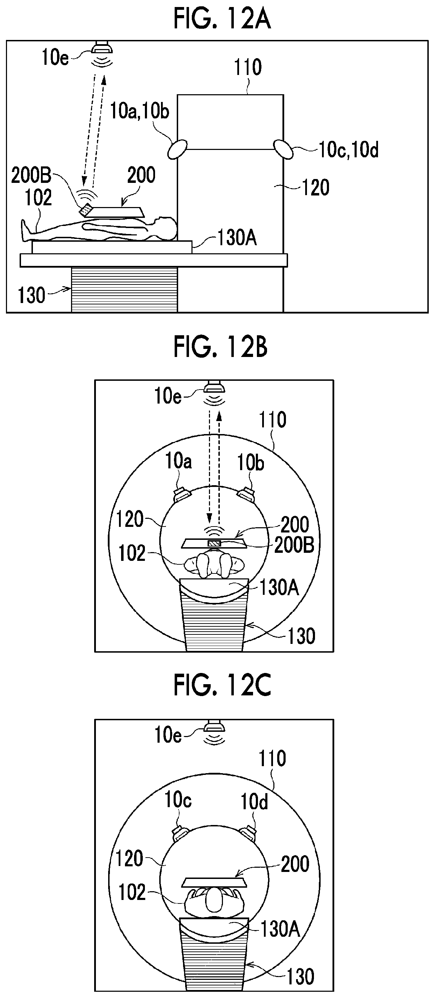

Figs. 12A to 12C are diagrams showing, for example, a positional relationship between the first optical communication device of the receive coil unit and a third optical communication device provided on the ceiling before the main scanning by the MRI apparatus.

Fig. 12A is a view showing, for example, the side of the gantry 110 and the bed 130 of the MRI apparatus, Fig. 12B is a left side view of Fig. 12A as viewed from the entrance side (bed side) of the bore 120, and Fig. 12C is a right side view of Fig. 12A as viewed from the opposite side of the bore 120.

As shown in Figs. 12A to 12C, a third optical communication device 10e is provided in a portion of the ceiling above the bed 130 in the examination room in which the MRI apparatus 100 is installed.

The third optical communication device 10e is an optical communication device having the same functions as the four second optical communication devices 10a to 10d provided on the ceiling of the bore 120, but is different in purpose from the four second optical communication devices 10a to 10d in that the third optical communication device 10e is used to acquire the link-up check information before the main scanning and is not used during the main scanning.

As shown in Figs. 12A to 12C, the third optical communication device 10e performs optical communication with the optical wireless module 200B (first optical communication device 227) of the receive coil unit 200 in a state before the operation of moving the top plate 130A to feed the subject 102 into the bore 120 is started after the setting of the receive coil unit 200 for the subject 102 is completed (a state before the main scanning), and the processor 20 acquires, from the third optical communication device 10e, the link-up check information indicating which of two or more second optical communication devices 10a to 10d is to be used during the main scanning.

However, the optical communication device from which the link-up check information is acquired is not limited to the third optical communication device 10e, and the processor 20 may acquire the link-up check information from the second optical communication devices (10a to 10d) 10 that can be linked up in the state before the main scanning, in addition to the third optical communication device 10e.

In addition, the third optical communication device 10e is not limited to the optical communication device provided on the ceiling of the examination room, but may be buried in the bed 130 or the top plate 130A.

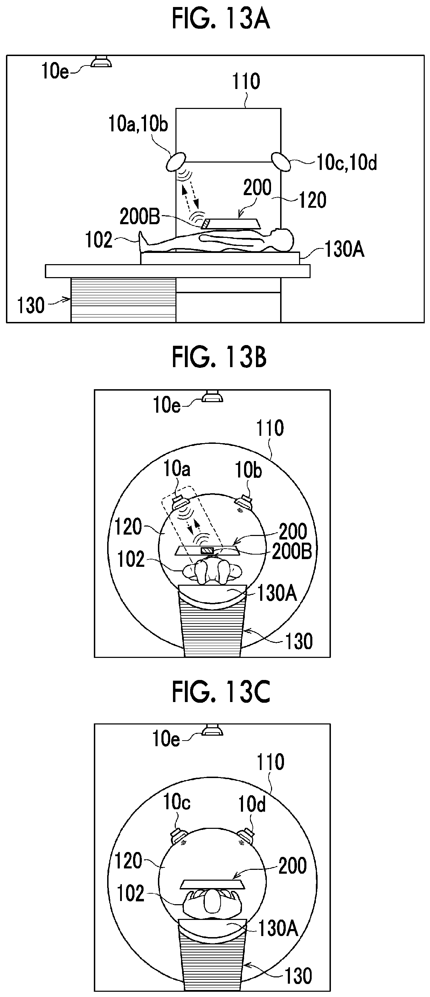

Figs. 13A to 13C are diagrams showing, for example, a positional relationship among the first optical communication device of the receive coil unit, the four second optical communication devices disposed in the bore of the gantry of the MRI apparatus, and the third optical communication device provided on the ceiling of the examination room during the main scanning by the MRI apparatus.

Figs. 13A to 13C are diagrams corresponding to Figs. 12A to 12C, respectively, and are different from Figs. 12A to 12C in the position of the top plate 130A of the bed 130 (that is, the positions of the subject 102 and the receive coil unit 200).

During the main scanning by the MRI apparatus 100, the second optical communication device 10a is linked up to the first optical communication device of the receive coil unit 200 (optical wireless module 200B), and optical communication of information including the NMR signal and the like is performed.

### Others

The receive coil unit comprises the optical wireless module having the functions of the first optical communication device. However, the configuration of the optical wireless module is not limited to the present embodiment and may be any configuration as long as the optical wireless module can perform wireless optical communication with the second optical communication device.

In addition, in the present embodiment, two second optical communication devices are provided at the front-side positions of the ceiling in the bore of the gantry, and two second optical communication devices are provided at the back-side positions of the ceiling (a total of four second optical communication devices are provided). However, the number of second optical communication devices and the positions where the second optical communication devices are disposed are not limited thereto, and two or more second optical communication devices may be provided at least at different positions in the bore in the depth direction.

Further, in the present embodiment, for example, a hardware structure of the processing unit performing various processes, such as the CPU, is the following various processors. The various processors include, for example, a central processing unit (CPU) which is a general-purpose processor executing software (program) to function as various processing units, a programmable logic device (PLD), such as a field programmable gate array (FPGA), which is a processor whose circuit configuration can be changed after manufacture, and a dedicated electric circuit, such as an application specific integrated circuit (ASIC), which is a processor having a dedicated circuit configuration designed to perform a specific process.

One processing unit may be configured by one of these various processors or by two or more processors of the same type or different types (for example, a combination of a plurality of FPGAs or a combination of a CPU and an FPGA). Moreover, a plurality of processing units may be configured by one processor. A first example of the configuration in which a plurality of processing units are configured by one processor is an aspect in which one processor is configured by a combination of one or more CPUs and software and functions as a plurality of processing units. A representative example of this aspect is a client computer or a server computer. A second example of the configuration is an aspect in which a processor that implements the functions of the entire system including a plurality of processing units using one integrated circuit (IC) chip is used. A representative example of this aspect is a system-on-chip (SoC). As described above, various processing units are configured using one or more of the various processors as the hardware structure.

In addition, more specifically, the hardware structure of the various processors is an electric circuit (circuitry) obtained by combining circuit elements such as semiconductor elements.

Further, the present invention is not limited to the above-described embodiment, and it goes without saying that various modifications can be made without departing from the scope of the present invention as defined by the claims.

### Explanation of References

10, 10a, 10b, 10c, 10d: second optical communication device
10e: third optical communication device
12: O/E optical receiver
14: E/O optical transmitter
20: processor
100: MRI apparatus
102: subject
104: static magnetic field generating magnet
106: gradient magnetic field coil
108: transmission coil
110: gantry
112: high-frequency magnetic field generator
116: gradient magnetic field power supply
118: sequencer
120: bore
130: bed
130A: top plate
140: controller
150: operation unit
200: receive coil unit
200A: receive coil
200B: optical wireless module
202: coil element
204, 210: connector
212: preamplifier
214: filter
216: A/D converter
218: decimation
220: multiplexer
222: memory
224: E/O optical transmitter
226: O/E optical receiver
227: first optical communication device
228: demultiplexer
230: battery
232: charging port
S10 to S16, S20 to S60: step

## Claims

1. A wireless optical communication system comprising:
a first optical communication device (227) that is connected to a receive coil unit (200) attached to a subject (102);
two or more second optical communication devices (10) that are provided at a front-side position and a back-side position in a bore (120) of a gantry (110) of a magnetic resonance imaging apparatus and that are capable of performing wireless optical communication with the first optical communication device; and
a processor (20) that controls the optical communication between the first optical communication device and the second optical communication devices,
wherein the processor is configured to:
execute the optical communication between the first optical communication device and the second optical communication devices before main scanning by the magnetic resonance imaging apparatus is started and acquire link-up check information indicating which of the two or more second optical communication devices is to be used through the optical communication;
select the second optical communication device to be used for the main scanning from the two or more second optical communication devices based on the link-up check information; and
execute the optical communication between the first optical communication device and the selected second optical communication device and acquire a nuclear magnetic resonance signal received by the second optical communication device through the optical communication in a case where the main scanning is started.

2. The wireless optical communication system according to claim 1,
wherein the link-up check information is an offset position of the first optical communication device with respect to a reference position of the receive coil unit or a type or model number of the receive coil unit.

3. The wireless optical communication system according to claim 1,
wherein the link-up check information is a reception intensity of a signal received by each of the two or more second optical communication devices, and
the processor is configured to:
perform pre-scanning using the two or more second optical communication devices before the main scanning is started; and
select the second optical communication device to be used for the main scanning based on the reception intensity of the signal received by each of the two or more second optical communication devices in the pre-scanning.

4. The wireless optical communication system according to any one of claims 1 to 3,
wherein the receive coil unit (200) includes a memory (222) that stores an offset position of the first optical communication device with respect to a reference position of the receive coil unit or a type or model number of the receive coil unit, and
the processor (20) is configured to:
read out the offset position or the type or model number of the receive coil unit from the memory through the optical communication before the main scanning is started.

5. The wireless optical communication system according to claim 4,
wherein the processor (20) is configured to:
in a case where the type or model number of the receive coil unit (200) is acquired, acquire the offset position set according to the type or model number of the receive coil unit or information indicating the second optical communication device to be used for the main scanning.

6. The wireless optical communication system according to claim 4 or 5,
wherein the processor (20) is configured to:
acquire positional information of the first optical communication device above a top plate (130A) of a bed (130) on which the subject is placed, based on two or more received signals received by the two or more second optical communication devices through the optical communication before the main scanning is started.

7. The wireless optical communication system according to claim 2, further comprising:
a third optical communication device (10e) that is capable of performing wireless optical communication with the first optical communication device of the receive coil unit before movement of a top plate of a bed on which the subject is placed is started,
wherein the processor is configured to:
execute the optical communication between the first optical communication device and the third optical communication device before the main scanning is started to acquire the offset position of the first optical communication device with respect to the reference position of the receive coil unit or the type or model number of the receive coil unit.

8. The wireless optical communication system according to claim 7,
wherein the third optical communication device is provided on a ceiling above the bed.

9. The wireless optical communication system according to any one of claims 1 to 8,
wherein the processor (20) is configured to:
acquire information used to control a position of a top plate (130A) of a bed (130) on which the subject is placed through the optical communication before the main scanning is started; and
automatically or manually control the position of the top plate fed into the bore based on the acquired information such that the receive coil unit is moved to an imaging region in the bore.

10. The wireless optical communication system according to claim 6,
wherein the processor (20) is configured to:
control a position of the top plate (130A) based on the acquired offset position and positional information such that the reference position of the receive coil unit is moved to a center of an imaging region in the bore of the gantry or output assist information for manually moving the top plate and for moving the reference position of the receive coil unit to the center of the imaging region.

11. The wireless optical communication system according to any one of claims 1 to 10,
wherein the processor (20) is configured to:
acquire the link-up check information every repetition period of the main scanning or every several repetition periods of the main scanning.

12. A wireless optical communication method executed by a processor of a wireless optical communication system including a first optical communication device (227) that is connected to a receive coil unit (200) attached to a subject (102), two or more second optical communication devices (10a - 10d) that are provided at a front-side position and a back-side position in a bore (120) of a gantry (110) of a magnetic resonance imaging apparatus and that are capable of performing wireless optical communication with the first optical communication device, and the processor (20) that controls the optical communication between the first optical communication device and the second optical communication devices, the wireless optical communication method comprising:
a step of executing the optical communication between the first optical communication device and the second optical communication devices before main scanning by the magnetic resonance imaging apparatus is started and acquiring link-up check information indicating which of the two or more second optical communication devices is to be used through the optical communication;
a step of selecting the second optical communication device to be used for the main scanning from the two or more second optical communication devices based on the link-up check information; and
a step of executing the optical communication between the first optical communication device and the selected second optical communication device and acquiring a nuclear magnetic resonance signal received by the second optical communication device through the optical communication in a case where the main scanning is started.
